(19) Europäisches Patentamt
European Patent Office
Office européen des brevets

(11) Publication number: 0 134 697 B1

(12) **EUROPEAN PATENT SPECIFICATION**

(45) Date of publication of patent specification: **25.05.88**

(51) Int. Cl.$^4$: **H 01 L 31/18**, H 01 L 27/14, C 25 D 13/12, G 02 B 5/20, H 04 N 9/04

(21) Application number: **84305255.6**

(22) Date of filing: **02.08.84**

(54) **Method of manufacturing a colour filter on a solid state colour imaging device and a solid state colour imaging device.**

(30) Priority: **04.08.83 JP 142882/83**

(43) Date of publication of application: **20.03.85 Bulletin 85/12**

(45) Publication of the grant of the patent: **25.05.88 Bulletin 88/21**

(84) Designated Contracting States: **DE FR GB NL**

(56) References cited:
**EP-A-0 030 476**
**EP-A-0 040 984**
**DE-A-3 031 759**
**DE-A-3 133 164**

(73) Proprietor: **SEIKO INSTRUMENTS INC.**
**31-1, Kameido 6-chome Koto-ku**
**Tokyo 136 (JP)**

(72) Inventor: **Kamamori, Hitoshi**
**c/o Kabushiki Kaisha Daini Seikosha**
**6-31-1 Kameido Koto-ku Tokyo (JP)**
Inventor: **Suginoya, Mitsuru**
**c/o Kabushiki Kaisha Daini Seikosha**
**6-31-1 Kameido Koto-ku Tokyo (JP)**
Inventor: **Iwasa, Koji**
**c/o Kabushiki Kaisha Daini Seikosha**
**6-31-1 Kameido Koto-ku Tokyo (JP)**
Inventor: **Sano, Yutaka**
**c/o Kabushiki Kaisha Daini Seikosha**
**6-31-1 Kameido Koto-ku Tokyo (JP)**
Inventor: **Terada, Yumiko**
**c/o Kabushiki Kaisha Daini Seikosha**
**6-31-1 Kameido Koto-ku Tokyo (JP)**

(74) Representative: **Caro, William Egerton et al**
**J. MILLER & CO. Lincoln House**
**296-302 High Holborn**
**London WC1V 7JH (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).



Courier Press, Leamington Spa, England.

**Description**

This invention relates to methods of manufacturing colour filters on solid state colour imaging devices and to solid state colour imaging devices made thereby.

A colour television camera has a solid state imaging device consisting of a plurality of imaging elements such as charge coupled devices, bucket brigade devices or metal oxide semiconductors. The solid state imaging device requires a mosaic or strip-shaped colour filter for colour separation. In these conventional colour imaging devices, the colour filter, formed on the surface of a transparent substrate such as glass, is disposed on the solid state imaging device, the colour filter being precisely aligned with the imaging element. Such aligment is difficult, increases manufacturing cost and reduces yield. Therefore, in recent years it has been found advantageous that the colour filter is directly formed on the solid state imaging device by a so-called on-chip method.

There are two typical methods for directly forming a colour filter on a solid state imaging device. The first such method is illustrated in Figures 1(a) to 1(c).

Photo-sensitive liquid is applied over the surface of a solid state imaging device 1 by a roll coating technique, a dipping technique or a spinner technique. The photo-sensitive liquid contains dyeable resin such as polyvinyl alcohol, glue, gelatin and casein and is doped with ammonium bichromate to provide photosensitivity. The applied photo-sensitive liquid is dried to give a photo-sensitive layer. The photo-sensitive layer to be dyed a first colour is selectively exposed to light through a photo mask. Then the photo-sensitive layer is developed and those parts other than the photo chemically cured parts which are to be dyed to form a so-called dye base layer 2 are removed from the solid state imaging device 1. The dye base layer 2 is thus in a predetermined pattern. The dye base layer 2 is coloured by a first dye having predetermined spectral characteristics. A clear anti-dyeing material is applied over the solid state imaging device to form an anti-dyeing layer 3 which is not dyed by any dye (Figure 1(a)).

As shown in Figure 1(b) next a photo-sensitive liquid is applied over the anti-dyeing layer 3 and is dried to form a further photo-sensitive layer. The photo-sensitive layer is selectively exposed to light through a photo mask. The photo-sensitive layer is developed to form a second dye base layer 4. The second dye base layer 4 is coloured by a second dye having predetermined spectral characteristics different from the first dye. Anti-dyeing material is applied over the second dye base layer 4 to form a clear anti-dyeing layer 5.

Next, as shown in Figure 1(c), photo-sensitive liquid is applied over the anti-dyeing layer 5. The photo-sensitive liquid is dried to form a photo-sensitive layer. The photo-sensitive layer is selectively exposed to light through a photo mask and is developed to form a third dye base layer 6. The third dye base layer is coloured by a third dye having predetermined spectral characteristics different from the first and second dyes. Finally a top coat layer 7 is provided over the entire top surface to complete the colour filter.

Such a conventional method of manufacturing a colour filter has the following drawbacks.

(1) the first, second and third dye base layers 2,4,6 are disposed on different surfaces. The first dye base layer 2 is provided on the surface of the solid state imaging device and the second and third dye base layers are formed on the anti-dyeing layers 3, 5 respectively. the adhesive strength of the photo-sensitive liquid to different substances is different. For instance, some photo-sensitive liquid strongly adheres to the surface of the solid state imaging device (generally a silicon dioxide film) while the same photo-sensitive liquid is easily removed from an anti-dyeing layer.

(2) The anti-dyeing layers 3, 5 cause positional differences between the first, second and third dye base layers in the direction of the film thickness. Such positional differences reduce resolution of the colour filter. Therefore, the pattern of the second and third dye base layers is not sharp.

(3) The uneven surface of the solid state imaging device prevents the uniform application of photo-sensitive liquids so that the thickness of the dye base layer 2 is not constant. Consequently the colour density of the colour filter will not be constant. Accordingly, for the same reason it is difficult to form accurately mosaic or stri-shaped dyed regions.

(4) The light exposure procedure has to be repeated three times. The method is thus complicated and requires many manufacturing steps so that reduction in cost is difficult to achieve.

A second conventional method of manufacturing a colour filter on a solid state colour imaging device is illustrated in Figures 2(a) to 2(d). As shown in Figure 2(a) a dyeable resin is applied over the surface of a solid state imaging device 1 by a roll coat technique, a dipping technique or a spinner technique to form a dye base layer 2.

Next, as shown in Figure 2(b), a photoresist layer is formed on the dye base layer 2. The photoresist layer is photo etched to form a first dyeing mask 8 which has openings in a predetermined pattern. the dye base layer is selectively dyed through the openings by a first dye having predetermined spectral characteristics to form a first colour filter layer 21.

Next, as shown in Figure 2(c), a second dyeing mask 8′ having openings is formed by a light exposure technique. The dye base layer is selectively dyed through the openings by a second dye having predetermined spectral characteristics to form a second colour filter layer 22. Similarly a third colour filter layer 23 is formed to constitute the colour filter shown in Figure 2(c).

This conventional manufacturing method, in comparison with the first conventional manufacturing method, directly forms the dye base layer on the solid state imaging device and thus eliminates the

positional difference between different colour filter layers. Therefore, the drawbacks (1) and (2) of the first conventional manufacturing method are avoided. However, the second conventional manufacturing method suffers from the drawbacks (3) and (4) of the first conventional manufacturing method. Further, according to the second conventional manufacturing method, the first, second and third colour filter layers 21, 22, 23 are closely adjacent each other so that the dye tends to diffuse into adjacent regions and consequently different colours are mixed.

The present invention seeks to provide a method of manufacturing a colour filter on a solid state colour imaging device which has fine resolution of pattern, precise differently coloured regions and which does not have colour mixing between adjacent differently coloured regions.

According to one aspect of the present invention there is provided a method of manufacturing a colour filter on a solid state colour imaging device characterised by comprising the steps of: forming a plurality of transparent electroconductive strips electrically insulated from each other on a substrate provided with a plurality of imaging elements; forming a coloured layer on selected electroconductive strips by electrodeposition from a solution containing a polymer and first colouring matter; and forming a coloured layer on other selected electroconductive strips by electrodeposition from a solution containing the polymer and second colouring matter of a different colour from the first colouring matter.

The polymer may be an acrylic resin containing carboxyl groups or a polyester resin containing carboxyl groups and solubilised with alkali, or a mixture of an acrylic resin and a soluble melamine resin.

Preferably the colouring matter is a dye which is insoluble or only slightly soluble in water.

In one embodiment the step of forming the electroconductive strips comprises forming a transparent electroconductive film on the entire surface of the substrate, forming a photoresist layer on the electroconductive film, exposing the photoresist layer to light and developing the photoresist layer to form a predetermined mask, etching the transparent conductive film through the mask to form the electroconductive strips, and disposing a light blocking layer on the entire surface of the substrate and removing the mask and the light blocking layer to leave portions of the light blocking layer between the electroconductive strips.

According to a further aspect of the present invention there is provided a solid state colour imaging device comprising a plurality of transparent conductive strips electrically insulated from one another on a substrate provided with a plurality of imaging elements, a coloured layer comprising a polymer and first colouring matter deposited on selected electroconductive strips and a coloured layer comprising a polymer and second colouring matter of a different colour from the first colouring matter deposited on other selected electroconductive strips.

The invention is illustrated, mererly by way of example, in the accompanying drawings, in which:—

Figures 1(a) to 1(c) illustrate a first conventional method of manufacturing a colour filter on a solid state imaging device;

Figures 2(a) to 2(d) illustrate a second conventional method of manufacturing a colour filter on a solid state imaging device;

Figures 3(a) to 3(e) illustrate the first embodiment of a method according to the present invention of manufacturing a colour filter on a solid state colour imaging device; and

Figures 4(a) to 4(e) illustrate a second embodiment of a method according to the present invention of manufacturing a colour filter on a solid state colour imaging device.

Throughout the drawings like parts have been designated by the same reference numerals.

First a method of forming a coloured layer by electrodeposition of a polymer, which is an important aspect of the present invention, will be described. One of the methods of electrodepositing a polymer on an electrode is to polymerise a monomer on an electrode electrochemically. It has been reported that a polymer coating has been obtained by electrochemically polymerizing various vinyl compounds on an iron plate ("Kinzoku Hyomen Gijutsu" (Metal Surface Technology) Vol. 19, No. 12, 1968). Recently the production of an electroconductive polymer such as poly (2,5-pyrrole) or poly (2,5-thienyline) by electrochemically polymerising pyrrole of thiophene on an electrode have been actively studied. The method for electrochemically polymerising a monomer directly, however, has drawbacks: namely it is inefficient and lacks the option of selective colouration since the coating obtained is already coloured.

Another method of electrodepositing a polymer is to form an insoluble polymer from a polymer solution on an electrode. By way of example, an electrodeposition coating method has been known in industrial fields, in which a coloured layer is electrodeposited on a metal sheet, which serves as an electrode, by immersing the metal sheet in a polymer solution in which a pigment is dispersed. The electrodeposition coating method is used industrially for precoating automobile bodies, etc. The principle of this method is as follows: a hydrophilic group such as a carboxyl group is introduced into a polymer; the carboxyl group is neutralized and solubilised, for example, with inorganic alkali or an organic amine; an electrode is immersed in the solubilised polymer solution and a voltage is applied so that the carboxyl anions that have dissociated in the solution move by electrophoresis towards a positive electrode and react with protons produced by an electrolysis of water on the electrode whereby the polymer is made insoluble

and precipitates. In other words, the reaction expressed by the following equation occurs on the positive electrode and precipitation of the polymer can be observed:

$$2H_2O \rightarrow 4H^+ + O_2 \uparrow 4e^-$$

$$\tau COO^- + H^+ \rightarrow \tau COOH \qquad \text{(deposition)}$$

Conversely, if a basic group (e.g. a polyamine) is used as the hydrophilic group and it is neutralised and solubilised by an acid, the polymer is deposited on the negative electrode. If the polymer thus electrodeposited is electrically insulating, as the electrode is coated with polymer current will reduce, thus preventing any further growth of the coating so that no increase in coating thickness can be expected. Actually, however, a complete coating of polymer at the initial stage is prevented by bubbles of nascent oxygen resulting from the electrolysis of water, and a coating of a given thickness can be obtained before an electrically insulating layer of the polymer is formed. In electrodeposition coating, generally, a coloured coating of 10—20 µm thickness is obtained with an applied voltage of 100—200 V. However, it is desirable in the present invention that the coating is thinner, preferably less than 2 µm. For that, resin concentration, voltage and solvent composition must be set to optimum values as will be explained hereinafter. Due to the effect of electro-osmosis, the resultant coating has a low water content and is a uniform film with a higher bondability compared to a coating formed by conventional methods.

Examples of polymers for anionic electrodeposition, include adducts of natural drying oils with maleic acid, alkyd resins incorporating carboxyl groups, adducts of epoxy-resins with maleic acid, polybutadiene resins incorporating carboxyl groups, copolymers of acrylic acid or methacrylic acid and their esters. Organic compounds having other polymer or functional groups may be sometimes incorporated into a polymer structure.

When light is to be observed through a colour filter it must be transparent and an acrylic polymer or polyester polymer is suitable for the purpose. The number of hydrophilic groups such as carboxyl groups or hydroxyl groups in the polymer is important. If there are too many hydrophilic groups, the deposited coating will not be sufficiently insoluble and the resulting coating will be non-uniform. On the other hand, if there are too few hydrophilic groups, the solubility during neutralization will be insufficient.

Although the solvent for the polymer is principally water, it also contains a hydrophilic polymerisation solvent such as isopropyl alcohol, n-butyl alcohol, tert-butyl alcohol, methyl Cellosolve, ethyl Cellosolve, isopropyl Cellosolve, butyl Cellosolve, diethylene glycol methyl ether, diethylene glycol ethyl ether, or diaceton alcohol. The type and quantity of hydrophilic solvent also greatly affects the uniformity and thickness of the electrodeposited coating.

When the electrodeposited coating is to incorporate a pigment, charged pigment moves by electrophoresis together with the polymer and taken up into the resultant coating. In the case of a transparent colour filter, the hiding power of the pigment is not needed and when the coating is thin its tinting strength is reduced. Accordingly, in the present invention a dye may be electrodeposited with the polymer. To electrodeposit a dye with a polymer, it is necessary to charge the dye molecules to cause electrophoresis. With a soluble dye, the dissociated dye ions serve as a current carrier which causes an increase in current, coating thickness and non-uniformity of the coating. Although insoluble dyes ordinarily cohere in water, the electrodeposited polymer can be regarded as a kind of soap containing hydrophobic and hydrophilic groups which to some extent disperse the organic dye molecules so that with a suitable dispersion solvent the dye becomes fine particles and can be electrodeposited together with the polymer. In this case, the rate of electrodeposition of the dye must be similar to that of the polymer and this can be controlled by the composition of the solution.

## Example 1

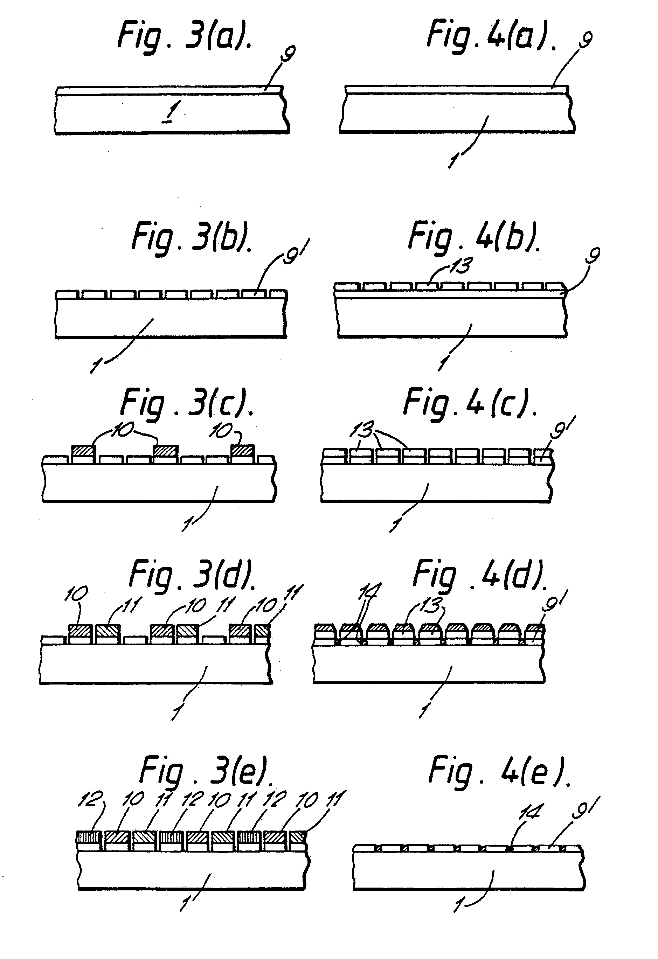

A method of manufacturing a colour filter on a solid state colour imaging device will now be described with reference to Figures 3(a) to 3(e).

*Patterning Process*

A transparent electroconductive layer 9 of tin oxide is formed by sputtering on a solid state imaging device 1 consisting of a substrate provided with a plurality of imaging devices such as charge coupled devices, bucket brigade devices or metal oxide semiconductors (Fig. 3(a)). the transparent electroconductive layer 9 is photo etched with a photoresist to form transparent electrodes 9′ in strips (Fig. 3(b)).

*Electrodeposition Process*

An electrodeposition bath is prepared using a paint S-Via ED—3000 (Registered Trade Mark: manufactured by Sinto Coating Co., Ltd.) having the following composition.

| Material | wt% |
|---|---|
| Soluble polyester resin<br>Soluble melamine resin | 70 wt% |
| Butyl Cellosolve<br>ethyl Cellosolve<br>n-butanol | 30 wt% |

The electrodeposition bath has the composition:

| Material | wt% |
|---|---|
| S-Via ED—3000 | 5 |
| Water | 120 |
| Methyl Cellosolve | 15 |
| Soluble dye | x |

The soluble dyes employed are restricted to those which are soluble in a hydrophilic solvent. They preferably have a metal complex salt structure with extremely light resistance. An example of such a dye has the following molecular structure:

(Aizen Spilon, Oleosol Fast, etc.).

Cr complex salt of 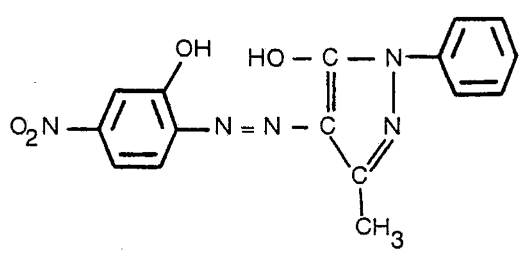

Color index No.: Solvent Red 8

The electrodeposition bath is prepared as follows. First the S-Via ED—3000 is dissolved in water to form an aqueous solution, and the dye is dissolved in the methyl-Cellosolve. In this instance the dye weight ration x is selected to be within a range which does not exceed the solubility of the dye in the methyl-Cellosolve. The methyl-Cellosolve in which the dye is dissolved is added to the aqueous solution so that the dye is uniformly dispersed. Altbough the methyl-Cellosolve serves as a dispersion medium, if a large quantity of methyl-Cellosolve is used or there is a large number of carbon atoms in the alkyl groups of the methyl-Cellosolve, the thickness of the coating will increase and the coating will be non-uniform.

The solid state imaging device 1 on which the transparent electrodes 9′ are formed is immersed in the electrodeposition bath described above. Transparent electrodes to be coloured identically are selected. A voltage of 10 V is applied for 3 minutes using the selected electrodes as the positive electrode. A large current flows immediately after the application of the voltage, and the current gradually reduces to approach almost zero. After the application of the voltage the solid state imaging device 1 is washed to remove electrodeposition bath from the transparent electrodes 9′ to which no voltage was applied. The solid state imaging device 1 is dried after washing and it was found that a coloured coating 10 with excellent transparency had been formed on the electrodes to which the voltage had been applied (Fig. 3 (c)).

*Curing Process*

The polyester and melamine resins in the coloured coating are subjected to a condensation reaction by baking and are cured. When the resins are cured in air at 175°C for 30 minutes, the coloured coating is completely cured. The thickness of the coloured coating on this occasion is 1.5 μm.

The cured coloured coating is a completely electrically insulating layer which cannot be re-electrodeposited or re-dyed even by being immersed in the electrodeposition bath again and having a voltage applied. Therefore, second and third coloured coatings 11, 12 are formed by repeating the processes of: selecting other transparent electrodes 9' to be coloured identically, electrodepositing a coloured coating in an electrodeposition bath in which a dye of a different colour is dispersed and curing (Fig. 3(d) and Fig. 3(e)).

In this embodiment coloured coatings in the form of strips are formed on the transparent electrodes of the solid state imaging device in the order of red, blue and green by the following extremely simple method: patterning step; electrodeposition step of a red coating; curing step; electrodeposition step of a blue coating; curing step; electrodeposition step of a green coating; curing step. Since the transparent electrodes are uniformly formed on the surface of the solid state imaging device irrespective of unevenness of the surface, by a spattering technique, very accurate patterning is possible. The coloured coatings are formed solely on the transparent electrodes so that the resultant colour filter has a very accurate pattern. The resolution of the pattern is sufficient. The problem of colours mixing between adjacent coloured coatings is eliminated. The adhesive strength between the coloured coating and the transparent electrodes is satisfactory.

The transparent electrodes may be formed by an evaporating technique or a spray coating technique rather than a spattering technique, to obtain the same effect.

Example 2

POWERMITE 3000—10 (Trade Mark: manufactured by Nippon Paint Co. Ltd.) of the following composition is used for the electrodeposition bath of Example 1:

| Material | wt% |
|---|---|
| Soluble acrylic resin<br>Soluble melamine resin | 60 wt% |
| Butyl Cellosolve<br>Isopropyl alcohol | 40 wt% |

The following is a composition of the electrodeposition bath:

| Material | wt% |
|---|---|
| POWERMITE 3000—10 | 10 |
| Water | 120 |
| Ethyleneglycol | 20 |
| Dispersion dyes | x |

The dispersion dyes on the market often contain an anionic dispersion agent. Since the dispersion agent bcomes ionised in the electrodeposition bath and causes the current to increase, it is desirable that the dispersion dye used does not contain any dispersion agent. The electrodeposition bath is mixed by uniformly dispersing the dispersion dye in the ethyleneglycol within the range of $x < 1.5$ and then adding the dispersion to an aqueous solution of the POWERMITE 3000—10.

A solid state colour imaging device is manufactured in a similar manner to that of Example 1 and had similar advantages.

Example 3

The composition of the electrodeposition bath of Example 1 was changed to the following composition:

| Material | wt% |
|---|---|
| S-Via ED—3000 | 20 |
| Water | 120 |
| Soluble dye | x |

In this case the electrodeposition bath is mixed by adding the soluble dye to the S-Via ED—3000 within the range of $x < 1.0$ and uniformly dispersed by kneading, ultrasonic waves, etc. Then the water is added to form the electrodeposition bath. Since the polymers in the electrodeposition bath is of high density, the coloured coating formed as in Example 1 is 20 μm in thickness.

Example 4

The formation of a light blocking layer between the transparent electrodes 9′ is shown in Figs. 4(a) to 4(e) in detail. First a transparent electroconductive layer 9 is formed on the entire surface of a solid state imaging device 1 (Fig. 4(a)). A photoresist resin is applied over the transparent electroconductive layer 9 to form a photoresist layer. The photoresist layer is selectively exposed to light and developed to form a mask 13 (Fig. 4(b)). the transparent electroconductive layer 9 is etched through the mask 13 to form strip-shaped electrodes 9′ (Fig. 4(c)). A resin layer 14 containing black dye is applied over the solid state imaging device and dried to form an electrically insulating light blocking layer (Fig. 4(d)). The photoresist mask 13 is removed from the transparent conductive layer together with the light blocking layer (Fig. 4(e)).

After that the same steps of Example 2 were performed to obtain a solid state colour imaging device having the light blocking layers between the transparent electrodes 9′.

Further a light blocking layer may be formed by evaporating metal oxide or formed by dyeing black the dyeable resin layer applied over the solid state colour imaging device 1.

In a method according to the present invention for manufacturing a colour filter on a solid state colour imaging device a transparent electroconductive layer is formed on the solid state imaging device. A colour filter is electrodeposited on the transparent electroconductive layer from an electrodeposition bath containing a polymer and colouring matter.

Conventionally dyeable resin is applied over the solid state imaging device by, for example, a spin coating technique, a dipping technique, etc. Because of the unevenness of the surface of the solid state imaging device, the dyeable resin is not uniformly applied to the solid state imaging device. Such a drawback causes lack of colour uniformity of the colour filter and lack of patterning accuracy. In the present invention, the transparent electroconductive layer is formed by a sputtering technique, an evaporating technique, etc. so that the electrodeposition layer is uniform without regard to unevenness of the surface of the solid state imaging device. Quite accurate patterning of the transparent electroconductive layer is thus obtained. Accordingly, the colour filter electrodeposited on the transparent electroconductive layer is also precise and uniform. The drawbacks of the conventional manufacturing methods are lack of pattern accuracy, pattern resolution and colour mixing between adjacent differently colouring layers. Further, with respect to the conventional manufacturing methods, three complicated light exposure steps including mask alignment are required, while in the present invention only a single patterning step of the transparent electroconductive layer is required. Thus the present invention offers a relatively simple method of manufacturing solid state colour imaging devices.

**Claims**

1. A method of manufacturing a colour filter on a solid state colour imaging device characterised by comprising the steps of: forming a plurality of transparent electroconductive strips (9′) electrically insulated from each other on a substrate (1) provided with a plurality of imaging elements; forming a coloured layer (10) on selected electroconductive strips (9′) by electrodeposition from a solution containing a polymer and first colouring matter; and forming a coloured layer (11, 12) on other selected electroconductive strips (9′) by electrodeposition from a solution containing the polymer and second colouring matter of a different colour from the first colouring matter.

2. A method as claimed in claim 1 characterised in that the polymer is an acrylic resin containing carboxyl groups or a polyester resin containing carboxyl groups or a polyester resin containing carboxyl groups and solubilised with alkali, or a mixture of an acrylic resin and a soluble melamine resin.

3. A method as claimed in claim 1 or 2 characterised in that the colouring matter is a dye which is insoluble or only slightly soluble in water.

4. A method as claimed in any preceding claim characterised in that the step of forming the electroconductive strips (9') comprises forming a transparent electroconductive film (9) on the entire surface of the substrate, forming a photoresist layer on the electroconductive film, exposing the photoresist layer to light and developing the photoresist layer to form a predetermined mask (13), etching the transparent conductive film through the mask (13) to form the electroconductive strips (9'), and disposing a light blocking layer (14) on the entire surface of the substrate and removing the mask (13) and the light blocking layer to leave portions of the light blocking layer (14) between the electroconductive strips (9').

5. A solid state colour imaging device characterised by comprising a plurality of transparent conductive strips (9') electrically insulated from one another on a substrate (1) provided with a plurality of imaging elements, a coloured layer (10) comprising a polymer and first colouring matter deposited on selected electroconductive strips (9') and a coloured layer (11, 12) comprising a polymer and second colouring matter of a different colour from the first colouring matter deposited on other selected electroconductive strips (9').

**Patentansprüche**

1. Verfahren zum Ausbilden eines Farbfilters auf einer Festkörperfarbabbildungsvorrichtung gekennzeichnet durch die Schritte: Bilden einer Vielzahl von transparenten elektrisch leitenden Streifen (9'), die elektrisch gegeneinander isoliert sind, auf einem Substrat (1), das mit einer Vielzahl von Abbildungselementen versehen ist, Bilden einer Farbschicht (10) auf gewählten elektrisch leitenden Streifen (9') durch galvanische Abscheidung aus einer Lösung, die ein Polymerisat und einen ersten Farbstoff enthält, und Bilden einer Farbschicht (11, 12) auf anderen gewählten elektrisch leitenden Streifen (9') über ein galvanische Abscheidung aus einer Lösung, die das Polymerisat und einen zweiten Farbstoff enthält, der eine gegenüber dem ersten Farbstoff andere Farbe hat.

2. Verfahren nach Anspruch 1, dadurch gekennzeichnet, daß das Polymerisat ein Acrylharz, das Carboxylgruppen enthält, oder ein Polyesterharz, das Carboxylgruppen enthält und mit Alkali lösbar gemacht ist, oder ein Gemisch aus einem Acrylharz und lösbarem Melaminharz ist.

3. Verfahren nach Anspruch 1 oder 2, dadurch gekennzeichnet, daß der Farbstoff eine Farbe ist, die in Wasser unlöslich oder in Wasser nur geringfügig löslich ist.

4. Verfahren nach einem der vorhergehenden Ansprüche, dadurch gekennzeichnet, daß der Schritt der Bildung der elektrisch leitenden Streifen (9') die Bildung eines transparenten, elektrisch leitenden Films (9) auf der gesamten Oberfläche des Substrates, die Bildung einer Fotoresistschicht auf dem elektrisch leitenden Film, die Belichtung der Fotoresistschicht mit Licht und die Entwicklung der Fotoresistschicht zur Bildung einer bestimmten Maske (13), das Ätzen des transparenten leitenden Films durch die Maske (13) zur Bildung der elektrisch leitenden Streifen (9') und das Anordnen einer lichtblockierenden Schicht (14) auf der gesamten Oberfläche des Substrates und Entfernen der Maske (13) und der lichtblockierenden Schicht umfaßt, derart, daß Teile der lichtblockierenden Schicht (14) zwischen den elektrisch leitenden Streifen (9') verbleiben.

5. Festkörperfarbabbildungsvorrichtung dadurch gekennzeichnet, daß sie eine Vielzahl von transparenten leitenden Streifen (9'), die gegeneinander elektrisch isoliert sind, auf einem Substrat (1), das mit einer Vielzahl von Abbildungselementen versehen ist, eine Farbschicht (10), die ein Polymerisat und einen ersten Farbstoff umfaßt und auf gewählten elektrisch leitenden Streifen (9') niedergeschlagen ist, und eine Farbschicht (11, 12) umfaßt, die ein Polymerisat und einen zweiten Farbstoff mit einer gegenüber dem ersten Farbstoff anderen Farbe umfaßt und auf anderen gewählten elektrisch leitenden Streifen (9') niedergeschlagen ist.

**Revendications**

1. Une méthode de fabrication d'un filtre de couleur sur un dispositif analyseur d'image de couleur à l'état solide caractérisée en ce qu'elle comprend les étapes suivantes: formation de plusieurs bandes électroconductrices transparentes (9') isolées électriquement les unes des autres sur un substrat (1) muni de plusieurs éléments d'image; formation d'une couche colorée (10) sur des bandes électroconductrices (9'), choisies par dépôt électrolytique à partir d'une solution contenant un plymère et une première matière colorante; et formation d'une couche colorée (11, 12) sur d'autres bandes électroconductrices (9') choisies par dépôt électrolytique à partir d'une solution contenant le polymère et une seconde matière colorante d'une couleur différente de la première matière colorante.

2. Une méthode selon la revendication 1, caractérisée en ce que le polymère est une résine acrylique contenant des groupes carboxyles ou un résine de polyester contenant des groupes carboxyles et solubilisée avec un alcali, ou un mélange d'une résine acrylique et d'une résine de mélamine soluble.

3. Une méthode selon la revendication 1 ou 2, caractérisée en ce que la matière colorante est un colorant qui est insoluble ou seulement légèrement soluble dans l'eau.

4. Une méthode selon l'une quelconque des revendications précédentes, caractérisée en ce que l'étape de formation des bandes électroconductrices (9') comprend la formation d'un film électroconducteur transparent (9) sur la surface entière du substrat, la formation d'une couche de photorésist sur le film électroconducteur, l'exposition de la couche de photorésist à la lumière et le développement de la couche

de photorésist pour former un masque prédéterminé (13), l'attaque par gravure du film conducteur transparent à travers le masque (13) pour former les bandes électroconductrices (9'), et le dépôt d'une couche de blocage de lumière (14) sur la surface entière du substrat et l'élimination du masque (13) et de la couche de blocage de lumière pour laisser des portions de la couche de blockage de lumière (14) entre les bandes électroconductrices (9').

5. Un dispositif analyseur d'image de couleur à l'état solide, caractérisé en ce qu'il comprend plusieurs bandes conductrices transparentes (9') isolées électriquement les unes des autres sur un substrat (1) muni de plusieurs éléments d'image, une couche colorée (10) comprenant un polymère et une première matière colorante déposée sur des bandes électroconductrices (9') choisies et une couche colorée (11, 12) comprenant un polymère et une seconde matière colorante d'une couleur différente de la première matière colorante déposée sur d'autres bandes électroconductrices choisies (9').

Fig. 1(a).

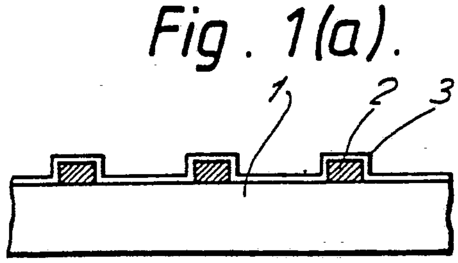


Fig. 2(a).

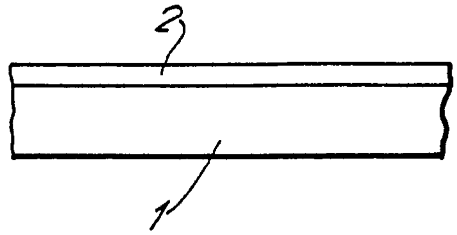


Fig. 1(b).

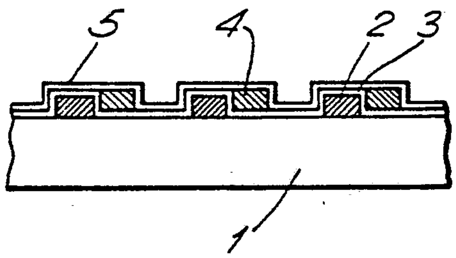


Fig. 2(b).

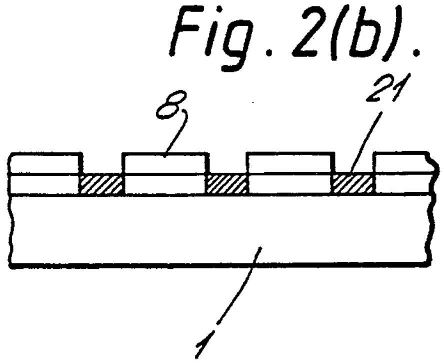


Fig. 1(c).

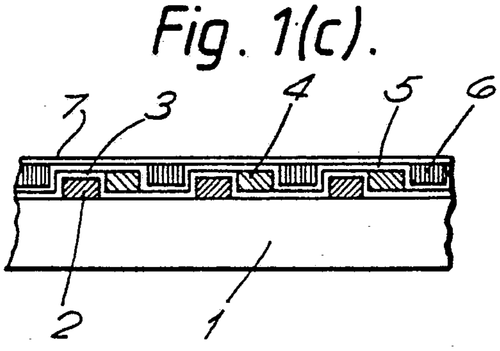


Fig. 2(c).

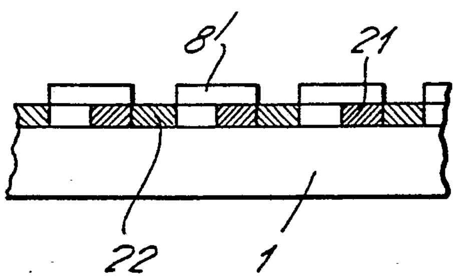


Fig. 2(d).

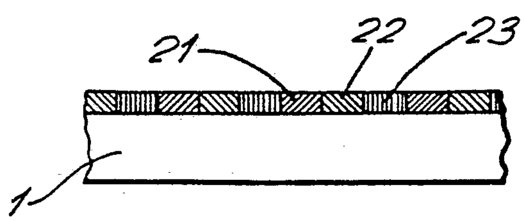

Fig. 3(a).

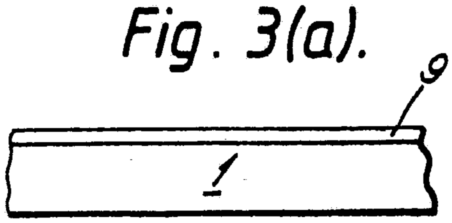


Fig. 3(b).

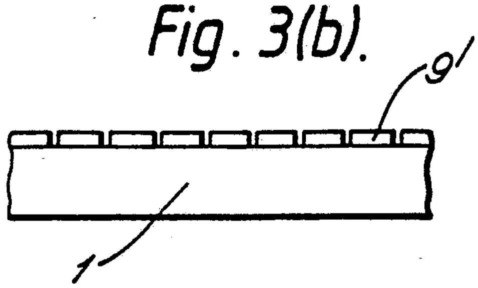


Fig. 3(c).

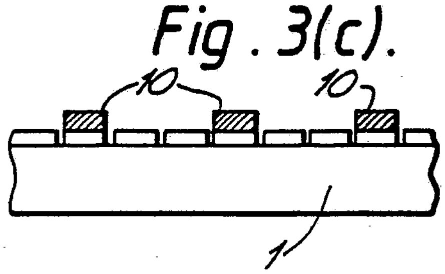


Fig. 3(d).

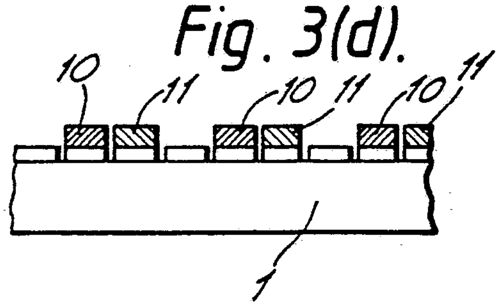


Fig. 3(e).

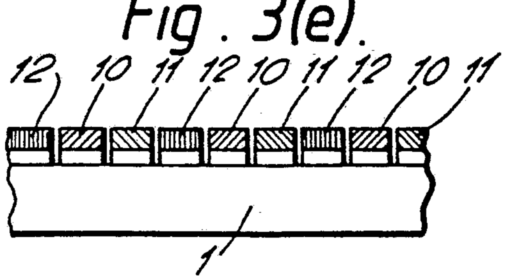


Fig. 4(a).

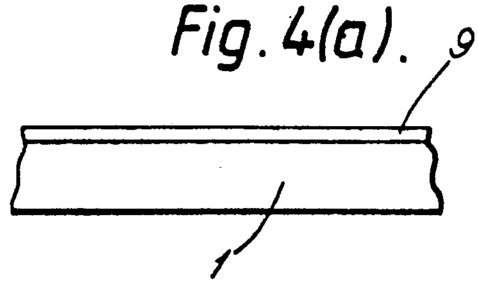


Fig. 4(b).

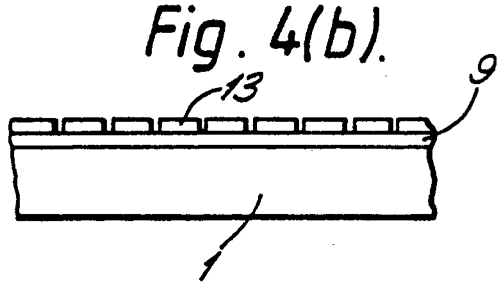


Fig. 4(c).

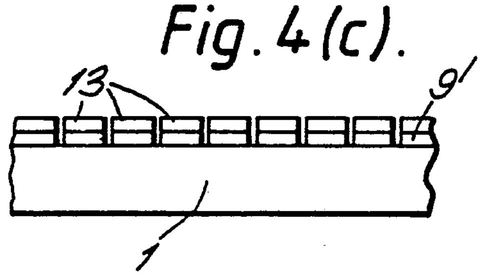


Fig. 4(d).

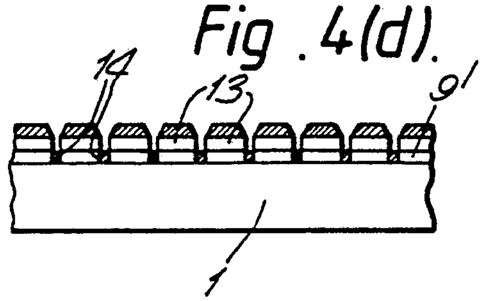


Fig. 4(e).